# EUROPÄISCHE PATENTSCHRIFT

(11) **EP 2 281 266 B1**
(45) Veröffentlichungstag und Bekanntmachung des Hinweises auf die Patenterteilung: **27.03.2013**
(21) Anmeldenummer: 09749531.1
(22) Anmeldetag: 28.04.2009
(51) Int. Cl.: G06K 19/077, H01Q 1/22, H01Q 9/28

(54) **ANTENNENANORDNUNG FÜR EINE CHIPKARTE**
ANTENNA ARRANGEMENT FOR A CHIP CARD
DISPOSITIF ANTENNE POUR CARTE À PUCE

(30) Priorität: 23.05.2008 DE 102008024790
(43) Veröffentlichungstag der Anmeldung: 09.02.2011
(73) Patentinhaber: Smartrac IP B.V., 1077 XX Amsterdam (NL)
(72) Erfinder: RIETZLER, Manfred, 87616 Marktoberdorf (DE); FREEMAN, Raymond, Mesa Arizona 85213 (US)
(74) Vertreter: von den Steinen, Axel
(86) Internationale Anmeldenummer: PCT/EP2009/003070
(87) Internationale Veröffentlichungsnummer: WO 2009/141041

(56) Entgegenhaltungen:
- EP-A- 0 451 059
- EP-A- 1 826 711
- WO-A-93/15418
- WO-A-2005/041121
- WO-A-2007/135269
- FR-A- 2 874 286
- US-A1- 2002 034 860
- US-A1- 2007 040 120

## Beschreibung

Die vorliegende Erfindung betrifft eine Chipkaxte unit einer Antennenanordnung gemäß Ansprüch 1.

Antennenanordnungen der eingangsgenannten Art werden bei Transpondern eingesetzt, die im UHF-Frequenzbereich betrieben werden. Bei derartigen UHF-Transpondern werden die Antennen häufig als Dipolantenne ausgeführt, mit einem im Zentrum der Antennenleiterstruktur angeordneten Chip, der über eine Anschlussanordnung mit der Antennenleiterstruktur kontaktiert ist.

Derartige UHF-Transponder werden häufig als so genannte "tags" ausgeführt, die mit der Oberfläche des zu kennzeichnenden Produkts flächig verbunden sind. Dabei lassen sich für die Positionierung der tags Applikationsorte finden, die nicht der unmittelbaren Handhabung durch denjenigen, der das Produkt handhabt, also beispielsweise der Mitarbeiter im Groß- oder Einzelhandel, der vermittels eines mobilen Lesegerätes die Transponderdaten einließt oder das Kassenpersonal, das zur Rechnungserstellung die Transponderdaten mittels eines Lesegerätes einliest, unterliegen. Daher ergeben sich im Zusammenhang mit der Ausführung der Transponder als tags in der Kommunikation zwischen Transponder und Lesegerät in der Praxis kaum Probleme.

Anders ist der Fall jedoch gelagert, wenn mit einer Dipol-Antenne versehene Transponder im Handhabungsbereich angeordnet sind und somit eine vollständige oder teilweise Abdeckung der Dipol-Antenne durch einen Finger der den Transponder handhabenden Person zu einer Verstimmung ("detuning") der Frequenz des Transponders und somit zu einer Funktionsstörung in der Kommunikation zwischen dem Transponder und dem Lesegerät führen kann.

Dieses Problem stellt sich in einem besonderen Ausmaß, wenn mit einer Dipol-Antenne versehene Transponder in einer Chipkarte angeordnet sind, bei der schon aufgrund der kleinen Abmessungen der Chipkarte die Wahrscheinlichkeit, dass bei einer Handhabung der Karte die Dipol-Antenne zumindest teilweise abgedeckt wird, groß ist. Die üblicherweise von den tags her bekannte zentrale Anordnung des Transponders würde bei einer Chipkarte dazu führen, dass sich zum einen der Chip, und hier insbesondere der mechanisch sensible Verbindungsbereich des Chips zur Dipol-Antenne, im Zentrum der Biegebelastung einer Chipkarte angeordnet ist.

Darüber hinaus ergibt es sich schon aufgrund der kleinen Abmessungen einer Chipkarte, dass bei einem Griff der Chipkarte die Chipkarte regelmäßig zwischen dem Daumen und dem Zeigefinder und/oder dem Mittelfinger des Handhabenden geklemmt gehalten wird, und zwar so, dass Daumen und Finger etwa im Zentrumsbereich der Chipkartenoberfläche zur Anlage kommen. Bei einer Anordnung eines UHF-Transponders der eingangs genannten Art mit der bekannten zentralen Anordnung auf einem tag würde also mit größter Wahrscheinlichkeit zumindest ein Teilbereich der Dipol-Antenne durch den Daumen und mindestens einen Finger abgedeckt werden, mit den sich daraus ergebenden nachteiligen Konsequenzen für die Kommunikation zwischen dem Transponder und dem Lesegerät.

Aus der EP-A-1 826 711 ist ein RFID-Tag bekannt, der auf einem Kartensubstrat eine Antennenanordnung mit einer Dipolantenne und einem ersten und zweiten Antennenstrang aufweist. Darüber hinaus ist die Antennenanordnung mit einer Anschlussanordnung zum Anschluss an einen Chip versehen. In der bekannten Antennenanordnung bilden die Antennenstränge der Dipolanordnung über ihre variable Länge Abstimmungsbereiche aus, die zur Abstimmung eines aus der Antennenanordnung und dem damit kontaktierten Chip gebildeten Transponders dienen.

Dabei befindet sich ein durch die Erstreckung der Antennenanordnung definiertes Transponderfeld in zentraler Anordnung auf der Substratoberfläche.

Die WO 2007/135269 A zeigt ein Transponder-Etikett mit einer auf einem Substrat angeordneten Dipolantenne, die einen ersten Antennenstrang und einen zweiten Antennenstrang aufweist. Auf dem Substrat befindet sich ebenfalls eine Anschlussanordnung zum Anschluss der Antennenanordnung an einen Chip. Die Dipolantenne erstreckt sich im Wesentlichen längs eines Umfangsrands der Substratoberfläche. Ein durch die Dipolantenne begrenzter Innenbereich der Substratoberfläche ist im Wesentlichen durch eine Schleifenantenne ausgefüllt.

Aus der EP-A-0 451 059 ist eine Transponderanordnung bekannt, die auf einer Substratoberfläche eine Schleifenantenne und eine mit einem Chip kontaktierte Koppelantenne aufweist.

Die FR-A-2 874 286 zeigt ein Chipmodul, das auf der Rückseite eines Substrats einen Chip aufweist, der über Drahtleiter, die durch Substratausnehmungen durchgeführt sind, mit Anschlussflächen des Chipträgers verbunden ist, die sich auf der dem Chip gegenüberliegenden Oberfläche des Substrats befinden.

Der vorliegenden Erfindung liegt somit die Aufgabe zugrunde, eine Chipkaxte mit einer Antennenanordnung mit einer Dipol-Antenne vorzuschlagen, bei der das Risiko einer Verstimmung des Transponders erheblich reduziert ist.

Zur Lösung dieser Aufgabe weist die erfindungsgemäße Chipkaxte die Merkmale des Anspruchs 1 auf. Die erfindungsgemäβ Fransponderanordnung weist die Merkmale des Ansprüchs 15 auf. Bei der erfindungsgemäßen Chipkaxte ist die Dipolanordnung der Antennenleiterstruktur in einem als "Transponderfeld" bezeichneten Teil der Substratoberfläche des Kartensubstrats angeordnet, der sich außerhalb eines als "Grifffeld" bezeichneten Teils der Substratoberfläche befindet, so dass die Wahrscheinlichkeit, dass bei einem Kartengriff Teile der Dipolanordnung der Antennenleiterstruktur durch den Griff abgedeckt werden erheblich reduziert ist. Dadurch, dass sich das Grifffeld von einem Seitenrand des Substrats ausgehend über den Zentrumsbereich der Substratoberfläche hinaus erstreckt, kann von zumindest einem Seitenrand der Chipkarte her die Karte normal ergriffen werden, also mit einer Anordnung des Daumens und zumindest eines Fingers im Zentrumsbereich der Karte, ohne dass eine Verstimmung der Antenne die zwangsläufige Folge ist.

Erfindingsgemäβ erstreckt sich das Grifffeld über einen Eckbereich der Substratoberfläche, so dass nicht nur von zumindest einem Seitenrand der Chipkarte her ein Kartengriff ohne die Gefahr einer Verstimmung der Antenne besteht, sondern darüber hinaus auch die Karte von der Seite ergriffen werden kann, ohne dass es zu einer derartigen Verstimmung kommen könnte.

Gemäß einer weiteren vorteilhaften Ausführungsform ist ein Seitenrand des Grifffeldes durch einen Seitenrand der Substratoberfläche definiert, derart, dass zwei über den Seitenrand des Grifffeldes miteinander verbundene Eckbereiche des Grifffeldes und der Substratoberfläche zusammenfallen. Bei einer derartigen Ausgestaltung ist es möglich, sowohl von einem Seitenrand her als auch von zwei benachbarten Eckbereichen des Seitenrands her die Karte zu ergreifen, ohne das Risiko einer Verstimmung einzugehen.

Weiterhin kann das Risiko einer Antennenverstimmung auch dadurch reduziert werden, dass die Antennenstränge an ihren freien Enden als offene Leiterrahmen ausgebildet sind, so dass beispielsweise auch bei gleichlanger Ausgestaltung der Antennenstränge über eine unterschiedliche Gestaltung bzw. Größe der als offene Leiterrahmen ausgestalteten freien Enden der Antennenstränge eine den Antennensträngen jeweils zugeordnete unterschiedliche Frequenzabstimmung erfolgen kann.

Auch kann durch die Ausbildung der freien Antennenenden als Leiterrahmen eine relativ kurze Ausgestaltung der Antennenstränge erfolgen, so dass auch dadurch das Risiko einer Abdeckung der Antennenstränge durch ein Ergreifen der Chipkarte weiter reduziert werden kann.

Wenn gemäß einer besonders vorteilhaften Ausführungsform die Anschlussanordnung zum Anschluss der Antennenleiterstruktur an den Chip als Schleifendipol ausgebildet ist, mit einem Koppelleiterabschnitt, der parallel zu einem die Antennenstränge der Antennenleiterstruktur miteinander verbindenden Koppelleiterabschnitt der Antennenleiterstruktur angeordnet ist, ist es möglich, die Anschlussanordnung bzw. den mit der Anschlussanordnung kontaktierten Chip seitlich zu den Antennensträngen der Antennenleiterstruktur anzuordnen, wodurch die Antennenstränge noch weiter an den Seitenrand der Substratoberfläche verlegt werden können.

Als besonders vorteilhaft erweist es sich dabei, wenn der Koppelleiterabschnitt der Anschlussanordnung und der Koppelleiterabschnitt der Antennenleiterstruktur in einem Eckbereich der Substratoberfläche angeordnet sind, da somit zur Ausbildung der Antennenstränge im Wesentlichen die gesamte Länge einer Querseite sowie einer Längsseite eines Chipkartenzuschnitts bzw. der Substratoberfläche zur Verfügung stehen.

Wenn dabei die Koppelleiterabschnitte jeweils zwei in einem Winkel zueinander angeordnete Koppelschenkel aufweisen, die jeweils parallel zu einem Seitenrand der Substratoberfläche verlaufen, ist eine Positionierung der Antennenanordnung erreicht, bei der sowohl die Antennenstränge als auch die Anschlussanordnung weitestmöglich vom Zentrumsbereich der Substratoberfläche entfernt angeordnet sind.

Wenn die Anschlussanordnung zumindest zwei flächig ausgebildete Anschlusskontakte aufweist, die sich über zu einer Substratrückseite hin offene Substratausnehmungen erstrecken, ist es möglich, den Chip mit geringstmöglichem Abstand zur neutralen Biegeebene des Kartensubstrat zu positionieren und dabei den eigentlichen Kontaktierungsbereich zwischen den Anschlusskontakten der Anschlussanordnung und den Chipkontakten praktisch in die neutrale Ebene, also in einen bei einer Biegebelastung nahezu spannungsfreien inneren Bereich des Kartensubstrats zu verlegen. Damit können sowohl die im Verbindungsbereich auftretenden, als auch die auf den Chip wirkenden mechanischen Biegebelastungen minimiert werden.

Wenn die Anschlusskontakte einstückig mit dem Koppelleiterabschnitt der Anschlussanordnung als Materialbeschichtung in einem Beschichtungsverfahren auf das Kartensubstrat aufgebracht sind, entfällt auch die Notwendigkeit der Ausbildung von bruchgefährdeten Verbindungsstellen zwischen den Anschlusskontakten und dem Koppelleiterabschnitt.

Überhaupt erweist es sich als vorteilhaft, wenn die Antennenleiterstruktur und die darin ausgebildete Anschlussanordnung aus einer übereinstimmenden Materialbeschichtung gebildet sind, da somit die gesamte Antennenleiterstruktur in einem einzigen Beschichtungsvorgang herstellbar ist.

Wenn die Anschlussanordnung aus Aluminium oder einer Aluminium enthaltenden Legierung gebildet ist, kann insbesondere in dem Fall, dass der zur Kontaktierung mit der Anschlussanordnung vorgesehene Chip ebenfalls Anschlusskontakte aus Aluminium oder einer Aluminium enthaltenden Legierung aufweist, eine unmittelbare Kontaktierung der Chipanschlussflächen mit den Anschlusskontakten der Anschlussanordnung in einem Ultraschallschweißverfahren durchgeführt werden.

Wenn die Anschlussanordnung aus Kupfer oder einer Kupfer enthaltenden Legierung gebildet ist, ist eine Kontaktierung mit einem Chip vermittels eines der üblichen thermischen Bondverfahren möglich.

Gemäß einer weiteren vorteilhaften Ausführungsform kann die Anschlussanordnung auf einem vom Kartensubstrat unabhängig ausgebildeten Chipträger ausgebildet sein, so dass eine Kontaktierung mit dem Chip unabhängig vom Kartensubstrat durchgeführt werden kann.

Auch in diesem Fall kann die Anschlussanordnung aus einer in einem Beschichtungsverfahren auf den Chipträger aufgebrachten Materialbeschichtung gebildet sein.

Insbesondere erweist es sich als vorteilhaft, die auf dem Kartensubstrat angeordnete Dipolanordnung aus zumindest einem Drahtleiter auszubilden, um die Dipolanordnung beispielsweise durch eine Verlegung des Drahtleiters auf der Oberfläche des Kartensubstrats herzustellen.

Erfindungsgemäß ist die Transponderanordnung mit einer auf einem Kartensubstrat angeordneten Antennenanordnung versehen, wobei das Kartensubstrat auf seiner Rückseite mit einem Chipmodul umfassend einen auf einem Chipträger angeordneten Chip versehen ist, derart, dass der Chipträger zu elektrischen Verbindung des Chips mit der Anschlussanordnung der Antennenleiterstruktur über in die Substratausnehmungen hineinragende Chipträgerkontakte mit den Anschlusskontakten der Anschlussanordnung kontaktiert ist.

Die erfindungsgemäße Transponderanordnung ermöglicht somit nicht nur eine Positionierung der Antennenanordnung in einem Bereich, der bei einem Ergreifen der Chipkarte mit großer Wahrscheinlichkeit frei von einer Abdeckung mit Daumen und Fingern bleibt, sondern ermöglicht eine Anordnung des Chips und des zwischen der Anschlussanordnung der Antennenleiterstruktur und den Chipträgerkontakten ausgebildeten Verbindungsbereichs unmittelbar benachbart bzw. in der neutralen Ebene des Kartensubstrats.

Wenn gemäß einer vorteilhaften Ausführungsform die Chipträgerkontakte und die Anschlusskontakte aus Aluminium oder eine Aluminium enthaltenden Legierung gebildet sind, ist eine unmittelbar Verbindung der Kontakte durch eine Ultraschallbeaufschlagung möglich.

Eine Anordnung des Chips auf derselben Oberfläche des Chipträgers wie die Chipträgerkontakte sorgt dafür, dass der Chip unmittelbar benachbart der Substratoberfläche angeordnet werden kann.

Wenn darüber hinaus der Chip so angeordnet ist, dass er in eine im Kartensubstrat zur Aufnahme des Chips ausgebildete Substratausnehmung eingreift, ist es möglich, den Chip selbst in der neutralen Ebene des Kartensubstrats anzuordnen.

Wenn Darüber hinaus die Substratausnehmungen zum Eingriff der Chiptragerkontakte und die Substratausnehmung zur Aufnahme des Chips im Wesentlichen fluchtend miteinander angeordnet sind, ist eine besonders schmalen Ausführung des Chipträgers möglich, so dass der Chipträger zusammen mit dem Chip möglichst dicht am Seitenrand des Kartensubstrats angeordnet werden kann.

Nachfolgend werden bevorzugte Ausführungsformen der Antennenanordnung sowie eine Ausführungsförm der Transponderanordnung anhand der Zeichnung näher erläutert.

Es zeigen:
- **Fig. 1**: ein Kartensubstrat einer Chipkarte während der Handhabung;
- **Fig. 2**: eine weitere Ausführungsform des Kartensubstrats;
- **Fig. 3**: Kartensubstrat;
- **Fig. 4**: eine Schnittdarstellung des in **Fig. 1** dargestellten Kartensubstrats längs dem Schnittlinienverlauf IV-IV in **Fig. 1****;**
- **Fig. 5**: das in **Fig. 4** in Schnittdarstellung dargestellte Kartensubstrat mit einem Chipmodul zur Ausbildung eines Transponders;
- **Fig. 6**: einen in einem Laminatverbund mit einem Kartensubstrat angeordneten Chipträger.

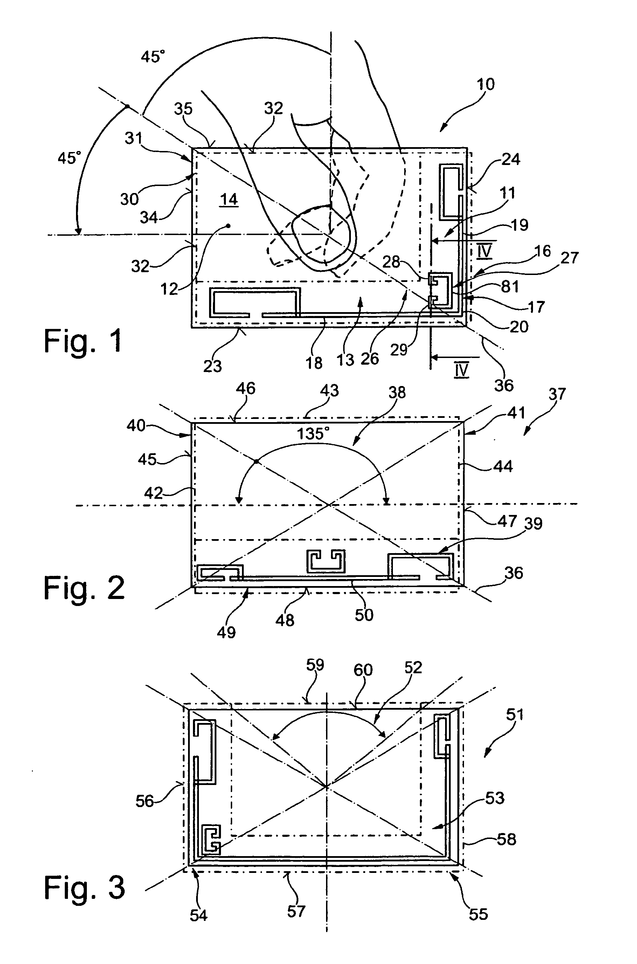

**Fig. 1** zeigt ein Kartensubstrat 10 in der Form und den Abmessungen einer Chipkarte. Bei der hier im Einzelnen nicht dargestellten Chipkarte bildet das in **Fig. 1** dargestellte Kartensubstrat 10 eine Lage der üblicherweise als Laminataufbau hergestellten Chipkarte, wobei die durch das Kartensubstrat 10 gebildete Lage zwischen äußeren Decklagen, die hier im Einzelnen nicht dargestellt sind, angeordnet ist.

Das in **Fig. 1** dargestellte Kartensubstrat 10 weist eine Substratoberfläche 11 auf, die in ein Grifffeld 12 und ein Transponderfeld 13 unterteilt ist. Dabei ist mit dem Grifffeld 12 der Bereich bezeichnet, in dem bei einem Griff eines Kartenbenutzers auf das Kartensubstrat 10 bzw. die Chipkarte eine zumindest teilweise Abdeckung der Substratoberfläche 11 auf einer Vorderseite 14 durch einen Daumen und auf einer Rückseite 15 durch einen oder mehrere Finger derselben Hand erfolgt, wie dies in **Fig. 1** angedeutet ist.

Bei dem in **Fig. 1** dargestellten Kartensubstrat ist das Transponderfeld 13 im Wesentlich L-förmig ausgebildet und nimmt eine Antennenleiterstruktur 16 auf, die zwei eine Dipolanordnung 17 ausbildende Antennenstränge 18 und 19 aufweist, welche über einen Koppelleiterabschnitt 20 einstückig miteinander verbunden sind. Die Antennenstränge 18, 19 weisen an ihren freien Enden jeweils offene Leiterschleifen bzw. Leiterrahmen 21, 22 auf, die im vorliegenden Fall unterschiedlich groß ausgebildet sind.

Die Dipolanordnung 17 der Antennenleiterstruktur 16 erstreckt sich bei dem in **Fig. 1** dargestellten Ausführungsbeispiel mit dem hier vergleichsweise länger ausgebildeten Antennenstrang 18 längs eines Längsseitenrands 23 des Kartensubstrats 10, und der vergleichsweise kürzer ausgeführte Antennenstrang 19 erstreckt sich längs eines Querseitenrands 24 des Kartensubstrats 10, derart, dass der die Antennenstränge 18, 19 verbindende Koppelleiterabschnitt 20 benachbart dem Längsseitenrand 23 und dem Querseitenrand 24 in einem Eckbereich 25 des Kartensubstrats angeordnet ist. In dem Eckbereich 25 befindet sich auch eine Anschlussanordnung 26 der Antennenleiterstruktur 16, die im vorliegenden Fall als Schleifendipol ausgebildet ist, mit einer im Wesentlichen U-förmigen Leiteranordnung 27, die an ihren freien Enden mit flächig ausgebildeten Anschlusskontakten 28 und 29 versehen ist. Die Anschlusskontakte 28 und 29 dienen zur Kontaktierung mit einem in **Fig. 1** nicht dargestellten Chip.

Die gesamte Antennenleiterstruktur 16, umfassend die Dipolanordnung 17 sowie die Anschlussanordnung 26, ist aus einer auf die Substratoberfläche 11 des Kartensubstrats 10 aufgebrachten metallischen Beschichtung, beispielsweise Aluminium oder Kupfer enthaltend, aufgebracht. Diese Beschichtung kann im Rahmen der im Stand der Technik bekannten Beschichtungsverfahren, also beispielsweise in einem Ätzverfahren oder in einem Bedruckungsverfahren, aufgebracht sein. Als Material für das Kartensubstrat können dabei insbesondere Kunststoffmaterialen, wie beispielsweise PVC, PETG, Polycarbonat und dergleichen, verwendet werden.

Unabhängig von der Materialauswahl für die Beschichtung und dem Auftragsverfahren zur Aufbringung der Beschichtung auf die Substratoberfläche 11 wirken bei dem in **Fig. 1** dargestellten Ausführungsbeispiel der Antennenleiterstruktur 16 die Anschlussanordnung 26 und die Dipolanordnung 17 so zusammen, dass zwischen der Anschlussanordnung 26 und der Dipolanordnung 17 eine elektromagnetische Kopplung im Bereich des Koppelleiterabschnitts 20 der Dipolanordnung 17 und einem Koppelleiterabschnitt 81 der Anschlussanordnung 26 entsteht. Hierdurch ist es möglich, eine Übermittlung von Empfangs- oder Sendefrequenzen zwischen der Dipolanordnung 17 der Antennenleiterstruktur 16 und einem mit den Anschlusskontakten 28, 29 der Anschlussanordnung 26 kontaktierten, hier nicht näher dargestellten Chip wegen der elektromagnetischen und somit berührungslosen Kopplung im Wesentlichen unbeeinflusst von störenden Kontaktstellen durchzuführen.

Wie aus der Darstellung gemäß **Fig. 1** deutlich wird, ermöglicht die Ausbildung des Grifffeldes 12 mit einem Eckbereich 30 des Grifffeldes 12, der mit einem Eckbereich 31 der Substratoberfläche 11 zusammenfällt, und Seitenrändern 32, 33 des Grifffeldes 12, die durch Seitenränder 34, 35 der Substratoberfläche 11 gebildet sind, eine großen Variabilität im Zugriff auf das Kartensubstrat 10, ohne dass es zu einer Überdeckung von Teilen der Dipolanordnung 17 durch Daumen oder Finger der zugreifenden Hand käme. So kann ausgehend von der in **Fig. 1** beispielhaft dargestellten Positionierung der Hand leicht ein Verschwenken der Hand um +/- 45 °C zu einer Kartendiagonale 36 erfolgen, ohne dass es zu einer derartigen Überdeckung käme.

**Fig. 2** zeigt ein Kartensubstrat 37 mit einem Grifffeld 38 und einem Transponderfeld 39, wobei sich das Grifffeld 38 über zwei benachbarte Eckbereiche 40 und 41 erstreckt und drei Seitenränder 42, 43, 44 aufweist, die durch Seitenränder 45, 36, 47 der Substratoberfläche 11 gebildet sind.

Das Transponderfeld 39 verläuft hier streifenförmig ausgebildet längs des weiteren Seitenrands 48 der Substratoberfläche 11 und nimmt eine Antennenleiterstruktur 49 auf, die eine Dipolanordnung 50 aufweist, die gradlinig ausgerichtet längs des Seitenrands 48 verläuft.

Wie aus einem Vergleich der **Fig. 1** und **2** hervorgeht, ermöglicht die in **Fig. 2** dargestellte Ausführung des Kartensubstrats 37 eine Variabilität der Griffposition bezogen auf die Kartendiagonale 26 zwischen - 45 °C und + 135 °C.

**Fig. 3** zeigt ein Kartensubstrat 51 mit einem Grifffeld 52 und einem Transponderfeld 53, das im Wesentlichen U-förmig ausgebildet ist und sich über zwei benachbarte Eckbereiche 54, 55 der Substratoborfläche 11 und längs den diesen Bekbereichen zugeordneten Seitenrändern 56, 57 und 58 erstreckt. Das Grifffeld weist daher lediglich einen von außerhalb des Kartensubatrats 51 frei zugänglichen Seitenrand 59 auf, der durch einen Seitenrand 60 der Substratoberfläche 11 gebildet ist, erstreckt sich jedoch ebenso wie die Grifffelder 12 und 38 bei den in den **Fig. 1** und **2** dargestellten Ausführungsformen des Kartensubstrats 10 und 37 in Kartentiefe über den Zentrumabereich 61 hinaus.

Ein Vergleich des in **Fig. 3** dargestellten Kartensubstrats 51 mit den in den **Fig. 1** und **2** dargestellten Kartensubstraten 10 und 37 zeigt, dass auch das Grifffeld 52 nur noch eine Variabilität im Zugriff auf das Kartensubstrat 51 ermöglicht, die bezogen auf eine Mittelachse 62 des Kartensubstrats 51 nur noch etwa +/- 30 **°**C beträgt.

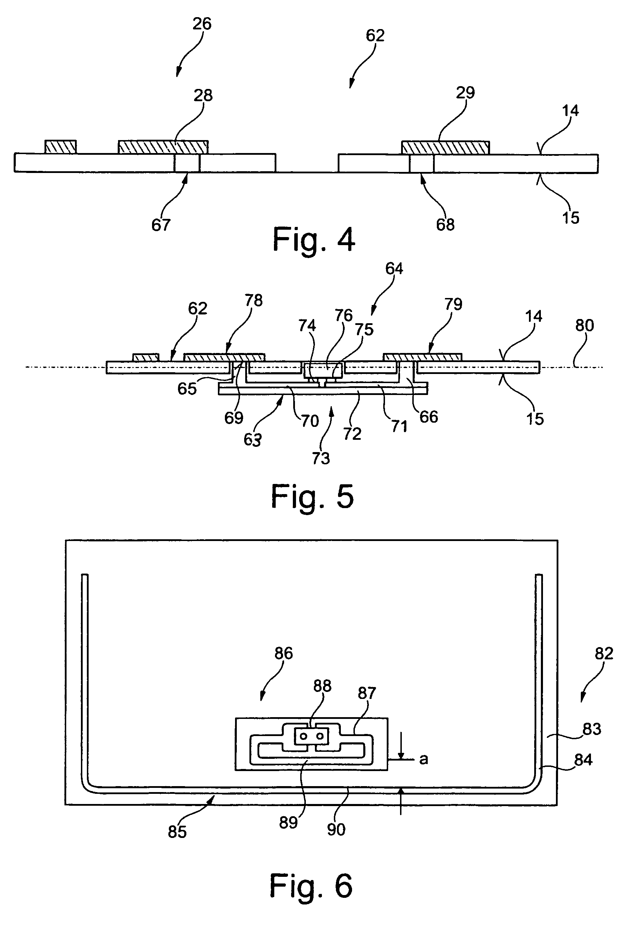

In den **Fig. 4** und **5** ist ein Längsschnitt des in **Fig. 1** dargestellten Kartensubatrats 10 dargestellt, wobei **Fig. 4** das Kartensubstrat 10 mit der darauf ausgebildeten Antennenleiterstruktur 16 und die Darstellung gemäß **Fig. 5** die Antennenleiterstruktur 16 kontaktiert mit einem Chipmodul 63 zur Ausbildung eines Transpondermoduls 64 zeigt.

Aus einer Zusammenschau der **Fig. 4** und 5 wird deutlich, dass das Chipmodul 63 zur Kontaktierung mit den Anschlusskontakten 28, 29 der Anschlussanordnung 26 über erhöhte Chipträgerkontakte 65, 66 in Substratausnchmungen 67, 68 eingreift und von der Rückseite 15 des Kartensubstrats 10 her mit einer Kontaktrückseite 69 der Anschlusskontakte 28, 29 verbunden ist. Die Chipträgerkontakte 65, 66 sind jeweils mit einem ersten und zweiten Anschlussleiter 70, 71 verbunden, die hier ebenfalls als metallisch leitende Beschichtung vergleichbar der Antennenleiterstruktur 16 auf einem hier als Folie ausgebildeten Substrat 72 eines streifenförmig ausgebildeten Chipträgers 73 angeordnet sind. Die einander zugewandten Enden der Anschlussleiter 70, 71 sind mit Chipkontakten 74, 75 eines Chips 76 kontaktiert, der sich auf derselben Seite des Chipträgers 73 befindet wie die Chipträgerkontakte 65 und 66 und in eine als Chipaufnahme im Kartensubstrat 10 ausgebildete Substratausnehmung 77 eingreift.

Wie aus der Darstellung gemäß **Fig. 5** deutlich wird, ermöglicht die vorstehende Kontaktierung bzw. Anordnung des Chips 76 mit der Anschlussanordnung 26 der Antennenleiterstruktur 16 eine Positionierung von zwischen den Chipträgerkontakten 65, 66 und den Anschlusskontakten 28, 29 der Anschlussanordnung 26 ausgebildeten Kontaktstellen 78, 79 sowie des Chips 76 im Bereich einer neutralen Biegeebene 80, in der die bei einer Biegebelastung des Kartensubstrats 10 auftretenden Spannungen minimal sind.

**Fig. 6** zeigt eine Transponderanordnung 82 mit einem Kartensubstrat 83 auf dessen Oberfläche eine aus einem Drahtleiter 84 gebildete Dipolanordnung 85 ausgebildet ist. Auf der Oberfläche des Kartensubtrats 83 befindet sich ebenfalls ein Chipträger oder Chipsubstrat 86, auf dem ein mit einer Anschlussanordnung 87 kontaktierte Chip 88 angeordnet ist. Die Anschlussanordnung 87 weist einen Koppelabschnitt 89 auf, der parallel zu einem auf dem Kartensubtrat 83 angeordneten Koppelabschnitt 90 der Dipolanordnung 85 mit definiertem Abstand a ausgerichtet ist und so eine Kopplung zwischen dem durch die Anschlussanordnung 87 gebildeten Schleifendipol und der Dipolanordnung 85 ermöglicht.

Zur Einstellung des Abstands a kann nach Belieben der Chipträger 86 auf das mit der Dipolanordnung 85 versehen Kartensubstrat 83 oder die Dipolanordnung 85 auf das zuvor mit dem Chipträger 86 versehen Kartensubstrat 83 aufgebracht werden.

## Patentansprüche

1. Chipkarte mit einer Antennenanordnung mit einer aus einem Oberflächenleiter gebildeten Antennenleiterstruktur (16, 49), wobei die Antennenleiterstcuktur eine auf einem Kartensubstrat (10, 83) angeordnete Dipolanordnung (17, 50, 85) mit einem ersten Antennenstrang (18) und einem zweiten Antennenstrang (19) sowie eine Anschlussanordnung (26, 87) zum Anschluss der Antennenleiterstruktur an einen Chip (76, 88) aufweist, wobei die Antennenleiterstruktur und der Chip einen Transponder bilden,
wobei eine Oberfläche (11) des Kartensubstrats in ein Grifffeld (12, 38, 52) zur Handhabung der Chipkarte und ein Transponderfeld (13, 39, 53) zur Anordnung des Transponders unterteilt ist, derart, dass sich das Grifffeld von einem Seitenrand der Substratoberfläche über einen Eckbereich (31) der Substratoberfläche und einen Zentrumsbereich (61) der Substratoberfläche hinaus erstreckt,
wobei der Eckbereich jeweils die halble lange der angsenzenden Seitenräncher umfasst.

2. Chipkarte nach Anspruch 1,
**dadurch gekennzeichnet,**
**dass** ein Seitenrand (43) des Grifffeldes (38) durch einen Seitenrand (46) der Substratoberfläche (11) definiert ist, derart, dass zwei über den Seitenrand des Grifffeldes miteinander verbundene Eckbereiche (40, 41) des Grifffeldes und der Substratoberfläche zusammenfallen.

3. Chipkarte nach Anspruch 1 oder 2,
**dadurch gekenntzeichnet,**
dass die Antennenstränge (18, 19) an ihren freien Enden als offene Leiterrahmen (21, 22) ausgebildet sind.

4. Chipkarte nach einem der vorangehenden Ansprüche,
**dadurch gekennzeichnet,**
das die Anschlussanordnung (26) zum Anschluss der Antennenleiterstruktur (16, 49) an den Chip (76) als Schleifendipol ausgebildet ist mit einem Koppelleiterabschnitt (81), der parallel zu einem die Antennenstränge der Antennenleiterstruktur miteinander verbindenden Koppelleiterabschnitt (20) der Antennenleiterstruktur angeordnet ist.

5. Chipkarte nach Anspruch 4,
**dadurch gekennzeichnet,**
**dass** der Koppelleiterabschnitt (81) der Anschlussanordnung (26) und der Koppelleiterabschnitt (20) der Antennenleiterstruktur (16) in einem Eckbereich (25) der Substratoberfläche (11) angeordnet sind.

6. Chipkarte nach Anspruch 5,
**dadurch gekennzeichnet,**
**dass** die Koppelleiterabschnitte (20, 81) jeweils zwei in einem Winkel zueinander angeordnete Koppelschenkel aufweisen, die jeweils parallel zu einem Seitenrand (47, 48) der Substratoberfläche (11) verlaufen.

7. Chipkarte nach einem der vorangehenden Ansprüche,
**dadurch gekennzeichnet,**
**dass** die Anschlussanordnung (26) zumindest zwei flächig ausgebildete Anschlusskontakte (28, 29) aufweist, die sich über zu einer Substratrückseite (15) hin offene Substratausnehmungen (67, 68) erstrecken.

8. Chipkarte nach Anspruch 7,
**dadurch gekennzeichnet,**
**dass** die Anschlusskontakte (28, 29) einstückig mit dem Koppelleiterabschnitt (81) der Anschlussanordnung (26) als Materialbeschichtung in einem Beschichtungsverfahren auf das Kartensubstrat (10) aufgebracht sind.

9. Chipkarte nach einem der vorangehenden Ansprüche,
**dadurch gekennzeichnet,**
**dass** die Antennenleiterstruktur (16, 49) und die Anschlussanordnung (26) aus einer übereinstimmenden Materialbeschichtung gebildet sind.

10. Chipkarte nach einem der vorangehenden Ansprüche,
**dadurch gekennzeichnet,**
**dass** die Anschlussanordnung aus Aluminium oder einer Aluminium enthaltenden Legierung gebildet ist.

11. Chipkarte nach einem der Ansprüche 1 bis 9,
**dadurch gekennzeichnet,**
**dass** die Anschlussanordnung aus Kupfer oder einer Kupfer enthaltenden Legierung gebildet ist.

12. Chipkarte nach einem der Ansprüche 1 bis 6,
**dadurch gekennzeichnet,**
**dass** die Anschlussanordnung (87) auf einem vom Kartensubstrat (83) unabhängig ausgebildeten Chipträger (86) angeordnet ist.

13. Chipkarte nach Anspruch 12,
**dadurch gekennzeichnet,**
**dass** die Anschlussanordnung (87) aus einer in einem Beschichtungverfahren auf den Chipträger (86) aufgebrachten Materialbeschichtung gebildet ist.

14. Chipkarte nach Anspruch 12 oder 13,
**dadurch gekennzeichnet,**
**dass** die auf dem Kartensubstrat (83) angeordnete Dipolanordnung (85) aus zumindest einem Drahtleiter (84) gebildet ist.

15. Chipkarte mit Transponderanordnung nach einem der Ansprüche 7 bis 11. wobei das Kartensubstrat (10) auf seiner Rückseite (15) mit einem Chipmodul (63) umfassend einen auf einem Chipträger (73) angeordneten Chip (76) versehen ist, derart, dass der Chipträger zur elektrischen Verbindung des Chips mit der Anschlussanordnung (26) der Antennenleiterstruktur (16) über in die Substratausnehmungen (67, 68) hineinragende Chipträgerkontakte (65, 66) mit den Anschlusskontakten (28, 29) der Anschlussanordnung (26) kontaktiert ist.

16. Chipkarte mit Transponderanordnung nach Anspruch 15,
**dadurch gekennzeichnet,**
**dass** die Chipträgerkontakte (65, 66) und die Anschlusskontakte (28, 29) aus Aluminium oder einer Aluminium enthaltenden Legierung gebildet sind.

17. Chipkarte mit Transponderanordnung nach Anspruch 15 oder 16, **dadurch gekennzeichnet,**
**dass** der Chip (76) auf derselben Oberfläche des Chipträgers (73) wie die Chipträgerkontakte (65, 66) angeordnet ist.

18. Chipkarte mit Transponderanordnung nach Anspruch 17,
**dadurch gekennzeichnet,**
**dass** der Chip (76) in eine im Kartensubstrat (10) zur Aufnahme des Chips ausgebildete Substratausnehmung (77) eingreift.

19. Chipkarte mit Transponderanordnung nach Anspruch 18,
**dadurch gekennzeichnet,**
**dass** die Substratausnehmungen (67, 68) zum Eingriff der Chipträgerkontakte (65, 66) und die Substratausnehmung (77) zur Aufnahme des Chips (76) im Wesentlichen fluchtend miteinander angeordnet sind.

## Claims

1. A chip card having an antenna arrangement, comprising an antenna conductor structure (16, 49) that is formed from a surface conductor, wherein the antenna conductor structure comprises a dipole arrangement (17, 50, 85) that is arranged on a card substrate (10, 83) and that has a first antenna strand (18) and a second antenna strand (19), and the antenna conductor structure comprises a terminal arrangement (26, 87) for connecting the antenna conductor structure to a chip (76, 88), wherein the antenna conductor structure and the chip form a transponder,
wherein a surface (11) of the card substrate is divided into a grasping zone (12, 38, 52) for handling the chip card and a transponder zone (13, 39, 53) for arranging the transponder in such a manner that the grasping zone extends from a lateral edge of the substrate surface beyond a corner region (31) of the substrate surface and beyond a centre region (61) of the substrate surface,
wherein the corner region respectively exhibits half the length of the adjacent lateral edges.

2. The chip card according to claim 1,
**characterised in that**
a lateral edge (43) of the grasping zone (38) is defined by a lateral edge (46) of the substrate surface (11) in such a manner that two corner regions (40, 41) of the grasping zone and of the substrate surface coincide, which corner regions are connected to one another via the lateral edge of the grasping zone.

3. The chip card according to claim 1 or 2
**characterised in that**
the antenna strands (18, 19) at their free ends are designed as open conductor frames (21, 22).

4. The chip card according to any of the preceding claims,
**characterised in that**
the terminal arrangement (26) for connecting the antenna conductor structure (16, 49) to the chip (76) is designed as a loop dipole having a coupling conductor section (81) being disposed in parallel to a coupling conductor section (20) of the antenna conductor structure, which connects the antenna strands of the antenna conductor structure with one another.

5. The chip card according to claim 4,
**characterised in that**
the coupling conductor section (81) of the terminal arrangement (26) and the coupling conductor section (20) of the antenna conductor structure (16) are disposed in a corner region (25) of the substrate surface (11).

6. The chip card according to claim 5,
**characterised in that**
the coupling conductor sections (20, 81) respectively feature two coupling arms which are disposed at an angle with respect to one another and which each extend in parallel to a lateral edge (47, 48) of the substrate surface (11).

7. The chip card according to any of the preceding claims,
**characterised in that**
the terminal arrangement (26) features at least two planarly formed terminal contacts (28, 29) which extend over substrate recesses (67, 68) being open towards a substrate rear side (15).

8. The chip card according to claim 7,
**characterised in that**
the terminal contacts (28, 29) are applied to the card substrate (10) integrally with the coupling conductor section (81) of the terminal arrangement (26) in the form of a material coating using a coating process.

9. The chip card according to any of the preceding claims,
**characterised in that**
the antenna conductor structure (16, 49) and the terminal arrangement (26) are formed of a congruent material coating.

10. The chip card according to any of the preceding claims,
**characterised in that**
the terminal arrangement is made of aluminium or an alloy containing aluminium.

11. The chip card according to any of claims 1 to 9,
**characterised in that**
the terminal arrangement is made of copper or an alloy containing copper.

12. The chip card according to any of claims 1 to 6,
**characterised in that**
the terminal arrangement (87) is disposed on a chip carrier (86) which is formed separately from the card substrate (83).

13. The chip card according to clam 12,
**characterised in that**
the terminal arrangement (87) is formed from a material coating applied to the chip carrier (86) using a coating process.

14. The chip card according to claim 12 or 13,
**characterised in that**
the dipole arrangement (85) being disposed on the card substrate (83) is formed from at least one wire conductor (84).

15. A chip card having a transponder arrangement according to any of claims 7 to 11, wherein the card substrate (10) on its rear side (15) is provided with a chip module (63) which comprises a chip (76) being arranged on a chip carrier (73) in such a manner that, for electrically connecting the chip to the terminal arrangement (26) of the antenna conductor structure (16), the chip carrier is contacted with the terminal contacts (28, 29) of the terminal arrangement (26) via chip carrier contacts (65, 66) extending into the substrate recesses (67, 68).

16. The chip card having a transponder arrangement according to claim 15,
**characterised in that**
the chip carrier contacts (65, 66) and the terminal contacts (28, 29) are formed of aluminium or an alloy containing aluminium.

17. The chip card having a transponder arrangement according to claim 15 or 16,
**characterised in that**
the chip (76) is disposed on the same surface of the chip carrier (73) as the chip carrier contacts (65, 66).

18. The chip card having a transponder arrangement according to claim 17,
**characterised in that**
the chip (76) engages into a substrate recess (77) formed in the card substrate (10) for accommodating the chip.

19. The chip card having a transponder arrangement according to claim 18,
**characterised in that**
the substrate recesses (67, 68) for engagement with the chip carrier contacts (65, 66) and the substrate recess (77) for accommodating the chip (76) are essentially disposed flush with respect to one another.

## Revendications

1. Carte à puce avec un dispositif d'antenne avec une structure de conducteur d'antenne (16, 49) formée d'un conducteur de surface, la structure de conducteur d'antenne comprenant un dispositif de dipôle (17, 50, 85) disposé sur le substrat de carte (10, 83) et ayant un premier brin d'antenne (18) et un deuxième brin d'antenne (19) ainsi qu'un dispositif de borne (26, 87) pour connecter la structure de conducteur d'antenne à une puce (76, 88), la structure de conducteur d'antenne et la puce formant un transpondeur,
dans lequel une surface (11) du substrat de carte est divisée en une zone de prise (12, 38, 52) pour la manipulation de la carte de puce et une zone de transpondeur (13, 39, 53) pour l'agencement du transpondeur, de telle manière que la zone de prise s'étende d'un bord latéral de la surface de substrat, dépassant une région de coin (31) de la surface de substrat et une région centrale (61) de la surface de substrat,
dans lequel la région de coin comprend respectivement la moitié de la longueur des bords latéraux adjacents.

2. Carte à puce selon la revendication 1,
**caractérisée en ce qu'**
un bord latéral (43) de la zone de prise (38) est défini par un bord latéral (46) de la surface de substrat (11) de telle manière que deux régions de coin de la zone de prise (40, 41) et de la surface de substrat, qui sont connectées entre elles par le bord latéral de la zone de prise (40, 41), coïncident.

3. Carte à puce selon la revendication 1 ou 2,
**caractérisée en ce que**
les brins d'antenne (18, 19) sont formés à leurs extrémités libres en tant que cadres de conducteur (21, 22) ouverts.

4. Carte à puce selon l'une quelconque des revendications précédentes,
**caractérisée en ce que**
pour la connexion de la structure de conducteur d'antenne (16, 49) à la puce (76), le dispositif de borne (26) est formé en tant que dipôle en boucle avec une section de conducteur de couplage (81) qui est disposée parallèlement à une section de conducteur de couplage (20) de la structure de conducteur d'antenne connectant entre eux les brins d'antenne de la structure de conducteur d'antenne.

5. Carte à puce selon la revendication 4,
**caractérisée en ce que**
la section de conducteur de couplage (81) du dispositif de borne (26) et la section de conducteur de couplage (20) de la structure de conducteur d'antenne (16) sont disposées dans une région de coin (25) de la surface de substrat (11).

6. Carte à puce selon la revendication 5,
**caractérisée en ce que**
les sections de conducteur de couplage (20, 81) comprennent respectivement deux bras de couplage, disposés en formant un angle l'un par rapport à l'autre, s'étendant respectivement parallèlement à un bord latéral (47, 48) de la surface de substrat (11).

7. Carte à puce selon l'une quelconque des revendications précédentes,
**caractérisée en ce que**
le dispositif de borne (26) comprend au moins deux contacts de borne (28, 29) formés plans et s'étendant sur des évidements de substrat (67, 68) étant ouverts vers un côté arrière du substrat (15).

8. Carte à puce selon la revendication 7,
**caractérisée en ce que**
les contacts de borne (28, 29) sont appliqués d'un seul tenant avec la section de conducteur de couplage (81) du dispositif de borne (26) en tant que revêtement de matériau sur le substrat de carte (10) par un procédé de revêtement.

9. Carte à puce selon l'une quelconque des revendications précédentes,
**caractérisée en ce que**
la structure de conducteur d'antenne (16, 49) et le dispositif de borne (26) sont formés d'un revêtement de matériau conforme.

10. Carte à puce selon l'une quelconque des revendications précédentes,
**caractérisée en ce que**
le dispositif de borne est formé d'aluminium ou d'un alliage contenant de l'aluminium.

11. Carte à puce selon l'une quelconque des revendications 1 à 9,
**caractérisée en ce que**
le dispositif de borne est formé de cuivre ou d'un alliage contenant du cuivre.

12. Carte à puce selon l'une quelconque des revendications 1 à 6,
**caractérisée en ce que**
le dispositif de borne (87) est disposé sur un support de puce (86) formé séparément du substrat de carte (83).

13. Carte à puce selon la revendication 12,
**caractérisée en ce que**
le dispositif de borne (87) est formé d'un revêtement de matériau appliqué sur le support de puce (86) par un procédé de revêtement.

14. Carte à puce selon la revendication 12 ou 13,
**caractérisée en ce que**
le dispositif de dipôle (85) disposé sur le substrat de carte (83) est formé d'au moins un conducteur en fil (84).

15. Carte à puce avec un dispositif de transpondeur selon l'une quelconque des revendications 7 à 11,
dans lequel le substrat de carte (10) est pourvu sur son côté arrière (15) d'un module à puce (63) comprenant une puce (76) disposée sur un support de puce (73) de telle manière que pour la connexion électrique de la puce au dispositif de borne (26) de la structure de conducteur d'antenne (16), le support de puce est contacté avec les contacts de borne (28, 29) du dispositif de borne (26) par des contacts de support de puce (56, 66) s'élevant dans les évidements de substrat (67, 68).

16. Carte à puce avec un dispositif de transpondeur selon la revendication 15,
**caractérisée en ce que**
les contacts de support de puce (65, 66) et les contacts de borne (28, 29) sont formés d'aluminium ou d'un alliage contenant de l'aluminium.

17. Carte à puce avec un dispositif de transpondeur selon la revendication 15 ou 16,
**caractérisée en ce que**
la puce (76) est disposée sur la même surface du support de puce (73) que les contacts de support de puce (65, 66).

18. Carte à puce avec un dispositif de transpondeur selon la revendication 17,
**caractérisée en ce que**
la puce (76) s'engage dans un évidement de substrat (77) formé dans le substrat de puce (10) pour recevoir la puce.

19. Carte à puce avec un dispositif de transpondeur selon la revendication 18,
**caractérisé en ce que**
les évidements de substrat (67, 68) pour l'engagement des contacts de support de puce (65, 66) et l'évidement de substrat (77) pour recevoir la puce (76) sont disposés essentiellement en alignement l'un par rapport à l'autre.
